Europäisches Patentamt

European Patent Office

Office européen des brevets

(11) Numéro de publication: **0 113 292 B1**

(12) **FASCICULE DE BREVET EUROPEEN**

(45) Date de publication du fascicule du brevet: **01.06.88**

(51) Int. Cl.⁴: **H 01 L 23/48,** H 01 L 23/04

(21) Numéro de dépôt: **83402527.2**

(22) Date de dépôt: **23.12.83**

(54) **Embase pour circuit intégré.**

(30) Priorité: **30.12.82 FR 8222069**

(43) Date de publication de la demande:
**11.07.84 Bulletin 84/28**

(45) Mention de la délivrance du brevet:
**01.06.88 Bulletin 88/22**

(84) Etats contractants désignés:
**DE GB IT**

(56) Documents cités:
**FR-A-2 033 678**

**ELECTRONIQUE INDUSTRIELLE, no. 31, 1 avril 1982, pages 105-114, Paris, FR. C. VAL et al.: "Le chip carrier, support universel de pastilles à haut niveau d'intégration"**

**PATENTS ABSTRACTS OF JAPAN, vol. 6, no. 211 (E-137)1089r, 23 octobre 1982**

(73) Titulaire: **XERAM**
**Tour Manhattan 6, place de l'Iris La Défense**
**F-92400 Courbevoie (FR)**

(72) Inventeur: **Lacruche, Bernard**
**THOMSON-CSF SCPI 173, bld Haussmann**
**F-75379 Paris Cedex 08 (FR)**
Inventeur: **Lebailly, Michel**
**THOMSON-CSF SCPI 173, bld Haussmann**
**F-75379 Paris Cedex 08 (FR)**

(74) Mandataire: **Séraphin, Léon et al**
**PECHINEY 28, rue de Bonnel**
**F-69433 Lyon Cedex 3 (FR)**

Courier Press, Leamington Spa, England.

## Description

La présente invention a pour objet une embase pour circuit intégré.

On connaît déjà de l'art antérieur des embases pour circuit intégré comportant des conducteurs de sortie organisés selon une rangée selon un pas donné qui, selon les technologies actuellement utilisées, ne peut être en pratique inférieur à 1,27 mm. Ce pas est obtenu notamment dans une configuration à pas décalés proposée par Texas Instruments et citée dans "Electronique Industrielle n° 31, 1er avril 1982, pages 105—114, Paris, France". Une autre configuration à pas réduit est proposée dans "Patent Abstracts of Japan, vol. 6, n° 211 (E—137) (1089), October 23, 1982". Pourtant, l'évolution des circuits intégrés et leur mise en oeuvre de plus en plus fréquente sous la forme de circuits hybrides a pour conséquence qu'il est de plus en plus nécessaire d'augmenter le nombre de conducteurs de sortie disponibles sur chaque boîtier.

La présente invention a pour objet une embase pour circuit intégré permettant d'augmenter le nombre de conducteurs de sortie disponibles sur chaque boîtier.

Dans ce but, l'embase comporte n (avec n supérieur ou égal à 2) rangées de conducteurs de sortie disposées à intervalle régulier sur le pourtour d'un boîtier selon un pas donné, ces conducteurs présentant des portions terminales dépassant du boîtier en vue de la connexion électrique de celui-ci sur un circuit d'utilisation les rangées étant décalées les unes par rapport aux autres de $l/n^{ième}$ de pas.

Elle est caractérisée en ce qu'au moins une rangée émerge d'au moins une face latérale du boîtier et au moins une autre rangée de la face inférieure du boîtier au voisinage du bord qui jouxte ladite face latérale. Les portions terminales des conducteurs de sortie de la rangée disposée sur la face latérale du boîtier peuvent être repliées vers le boîtier et celles des conducteurs de sortie de la rangée disposées sur la face inférieure du boîtier peuvent être repliées vers l'extérieur du boîtier.

Selon un mode de réalisation, l'embase comporte deux rangées de conducteurs de sortie disposées sur la face inférieure du boîtier. Ainsi, l'embase peut être en céramique et se distingue plus particulièrement en ce que les conducteurs sont du type sérigraphiés et en ce que ceux-ci comportent deux grilles superposées pour la connexion électrique depuis l'intérieur de l'embase jusqu'aux parois latérales de celles-ci, la grille supérieure étant raccordée électriquement à la partie inférieure de l'embase par des premières portions conductrices situées sur le bord du boîtier, disposées chacunbe dans une rainure, et se prolongeant par une patte située sous l'embase en vue de la connexion électrique de celles-ci, et la grille inférieure étant raccordée électriquement à la partie inférieure de l'embase par des secondes portions conductrices disposées dans des trous débouchant sur la face inférieure de l'embase, les secondes portions conductrices se prolongeant par une patte située sous l'embase en vue de la connexion électrique de celles-ci, les trous et les rainures étant décalés l'un par rapport à l'autre latéralement d'un demi-pas.

Dans les modes de réalisation où l'embase comporte des contacts repliés, ce repliement peut être réalisé autour d'un contour sensiblement parallélépipédique en matériau isolant de manière à protéger mécaniquement les conducteurs lors de la manipulation et de la mise en place de l'embase par soudure, et à donnerà l'ensemble une certaine élasticité permettant d'absorber les contraintes thermiques.

Dans tous les cas, le repliement peut être réalisé pour au moins une des rangées autour d'un contour sensiblement parallèlepipédique en matériau isolant et pour au moins une autre rangée après passage des conducteurs dans des ouvertures ménagées dans ledit contour.

Le contour peut comporter des faces latérales dont une au moins porte des rainures dans lesquelles les conducteurs sont guidés en amont de leurs extrémités repliées. Le contour peut être constitué par une pièce isolante maintenue en place par les connecteurs repliés autour d'elle.

Le boîtier peut être en matériau conducteur, comporter une plaquette intermédiaire disposée à l'intérieur du boîtier et destinée à recevoir au moins un circuit intégré, et au moins deux rangées de passages isolants décalées à travers lesquelles passent lesdits conducteurs de sortie.

L'invention sera mieux comprise à la lecture de la description qui va suivre, donnée à titre d'exemple non limitatif, en se reportant aux dessins annexés où:

— la figure 1 représente en perspective une embase selon un premier mode de réalisation de l'invention;

— la figure 2 représente une variante de la figure 1 dans le cas d'un boîtier métallique;

— les figures 3a et 3b représentent respectivement un détail en perspective des conducteurs de sortie du boîtier de la figure 2, et un bloc de connexions également en perspective;

— les figures 4, 5 et 6 représentent respectivement une variante d'un bloc représenté à la figure 3b, et des coupes suivant AA et BB de la figure 4;

— les figures 7a et 7b représentent chacune une feuille céramique à l'état cru pour la réalisation d'un boîtier céramique selon l'invention et représenté en coupe aux figures 8a et 8b;

— la figure 7c représente un secteur de la figure 7b;

— la figure 8c représente en vue de dessous un détail de l'embase des figures 8a et 8b;

— la figure 8d représente en vue de dessus un secteur présentant un cadre sérigraphié.

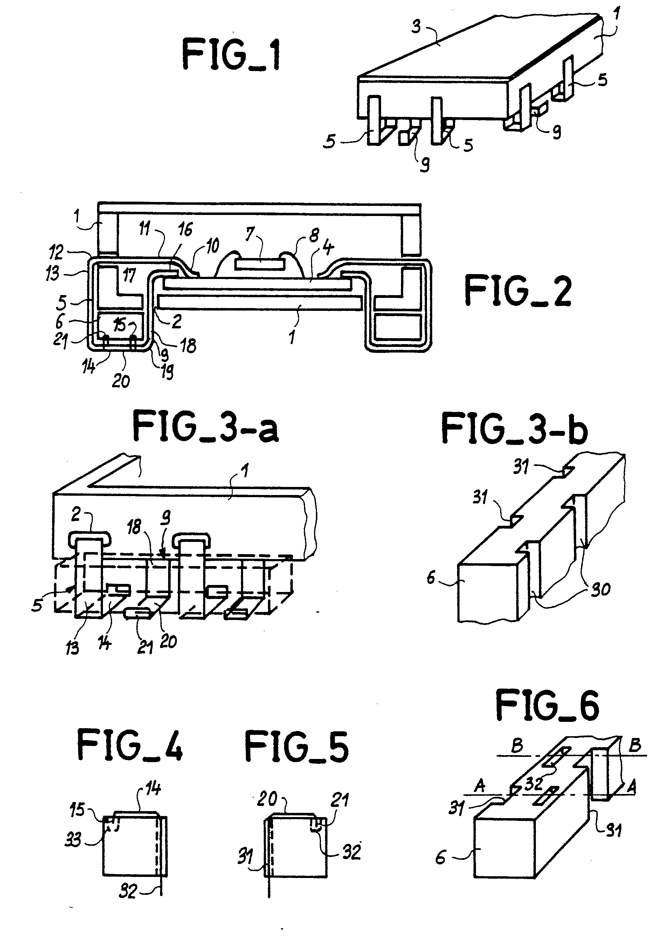

Selon la figure 1, un boîtier 1 pourvu d'un couvercle 3 présente sur ses faces latérales une rangée de connexions 5 disposée selon un pas donné et sur chacun des bords de sa face inférieure une rangée de conducteurs de sortie de même pas que la précédente mais décalée d'un demi pas par rapport à celle-ci. Les portions terminales des conducteurs de sortie 5 sont repliées vers l'intérieur du boîtier, alors que les portions terminales des conducteurs de sortie 9 sont repliées vers l'extérieur du boîtier, de manière à produire une structure inter-digitée. Sur le circuit imprimé sur lequel l'embase est fixée par soudure, les empreintes sont disposées de la même façon que pour les embases de l'art antérieur mais à un pas qui sera la moitié du pas précédemment utilisé, ce qui permet de multiplier par deux le nombre de conducteurs de sortie dont dispose l'embase, c'est-à-dire de disposer les conducteurs de sortie à un pas effectif de 0,635 mm.

Selon la figure 2, le boîtier 1, en matériau conducteur, est fermé par un couvercle 3 également en matériau conducteur. Des ouvertures 2 sont ménagées sur la face inférieure du boîtier et sur les faces latérales de manière à laisser passer des conducteurs de sortie 9 et 5 tels que ceux représentés à la figure 1. Une plaquette intermédiaire 4 reçoit un circuit intégré 7 relié par des fils de câblage 8 à une extrémité de conducteurs 9 et 5 situés sur le dessus de la plaquette intermédiaire 4. Les conducteurs 5 présentent à partir de leur extrémité de connexions 10, une section droite 11 permettant leur passage à travers les ouvertures 2 qui sont rendues étanches par des passages isolants par exemple des perles de verre. A sa sortie de l'ouverture 2, le conducteur 5 est replié une première fois perpendiculairement en 12 de manière à l'orienter vers la partie inférieure du boîtier puis, après une section droite 13, une nouvelle fois autour d'un bloc de connexions 6, la portion plane 14 repliée à 90° autour du bloc 6 formant la partie active du conducteur de sortie qui sera soudée sur un circuit imprimé. L'extrémité 15 du conducteur de sortie 5 peut être en outre repliée autour du bord du bloc de connexions 6 opposé à la section plane 13. En ce qui concerne le conducteur de sortie 9, il est replié en 17 à 90° de manière à permettre son passage par une ouverture 2 de la face inférieure du boîtier 1. Il traverse l'ouverture 2 sur une portion rectiligne 18 puis est ensuite replié en 19 vers l'extérieur du boîtier de façon qu'une portion rectiligne 20 vienne former contact électrique à la partie inférieure du bloc de connexions 6, l'extrémité 21 de la portion rectiligne 20 pouvant être en outre repliée autour du bloc 6 au niveau du bord opposé à celui que tangente la portion rectiligne 18. Le bloc 6 en matériau isolant est ainsi maintenu mécaniquement en place par les deux séries de contacts alternées 5 et 9 qui forment une structure inter-digitée et ils protègent en même temps ceux-ci contre les contraintes et les chocs mécaniques aussi bien que thermiques auxquels pourra être soumis le boîtier. Le bloc 6 peut être en vitrocéram ou en alumine. Il est particulièrement avantageux que le bloc 6 soit en matériau plastique de manière que l'ensemble formé par le bloc et les conducteurs soit susceptible d'absorber les différences de dilatation thermique éventuelles entre le boîtier et le substrat sur lequel il est destiné à être soudé. On pourra choisier un plastique tenant en température tel qu'un polysulfone.

On remarquera que la fabrication de ce boîtier peut être réalisée de manière classique, en mettant en oeuvre une cuisson des perles de verre dans les ouvertures 2 de manière à réaliser l'étanchéité du boîtier. On réalise cette cuisson avant repliement des connexions.

La figure 3a montre un détail en perspective du mode de réalisation de la figure 2 où le bloc 6 est représenté en pointillés.

Selon la figure 3b, ce bloc présente des rainures 30 et 31 destinées à recevoir les portions rectilignes 13 et 18 des conducteurs de sortie 5 et 9. Ce mode de réalisation permet d'obtenir un meilleur maintien réciproque du bloc 6 et des conducteurs de sortie.

Selon les figures 4 à 6, les extrémités 15 et 21 des conducteurs de sortie 5 et 9 sont introduits dans les trous borgnes respectivement 32 et 33 ménagés en face des raiures 30 et 31 à la face inférieure du bloc de connexions 6.

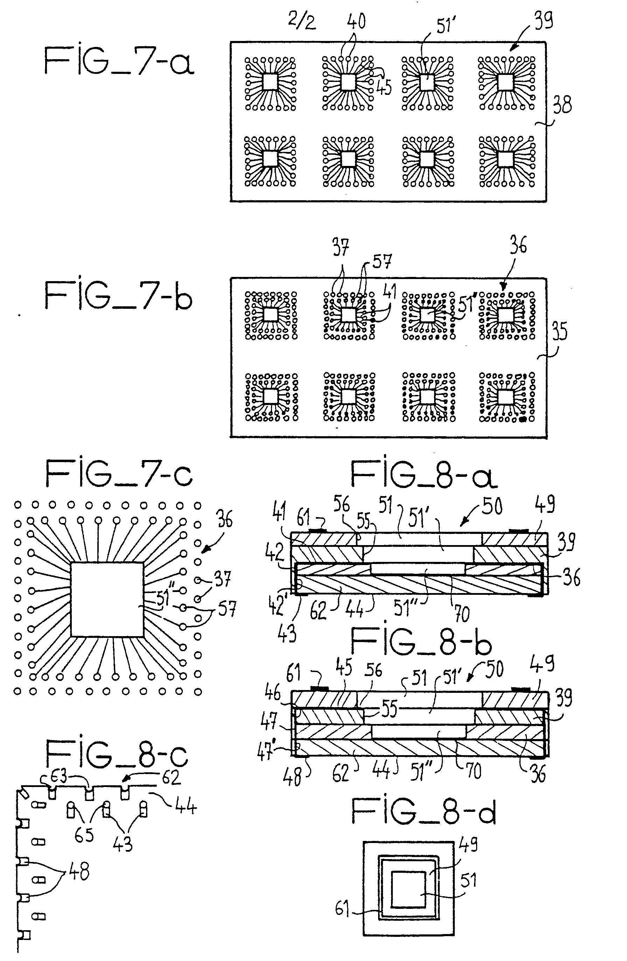

Selon la figure 7a, une feuille 38 en céramique crue comporte un certain nombre de secteurs carrés 39 dont le contour est défini par un grand nombre de perçages 40 égal à la moitié ou à peu près à la moitié (ici à la moitié plus deux) du nombre de sorties du boîtier, espacés du pas des connexions de chaque secteur 39 comportant en son centre une ouverture 51'.

Selon la figure 7b, une feuille 35 en céramique crue comporte un certain nombre de secteurs carrés 36 dont le contour est défini par une première rangée extérieure de perçages 37 en nombre égal à la moitié du nombre de sorties du boîtier et espacés du pas des connexions. Les perçages 37 s'inscrivent suivant un carré de même dimension que celui que forment les perçages 40. Sur un carré de côté plus petit, s'inscrit une deuxième rangée intérieure de perçages 57 en nombre à peu près égal à la moitié du nombre des sorties du boîtier et espacés du pas des connexions. Les perçages 57 sont décalés d'un demi-pas par rapport aux perçages 37. Chaque secteur 36 comporte en son contre une ouverture 51'' plus petite que l'ouverture 51'.

Les faces supérieures de chaque feuille 38 et 35 sont sérigraphiées de manière classique pour créer un motif de connexion respectivement 45 entre les trous 40 et l'ouverture 51' et 41 entre les trous 57 et l'ouverture 51''. Des aiguilles sont de manière connue en soi introduites dans les ouvertures 37, 40 et 57 pour y faire pénétrer la pâte à sérigraphier et la faire déposer sur les bords desdites ouvertures. Les feuilles à traiter sont, à cet effet, disposées de manière connue en soi au-dessus d'une réserve de pâte à sérigraphier dans laquelle plongent les aiguilles. Selon une variante également connue, la pâte à sérigraphier est aspirée à travers l'écran de sérigraphie pourvu à cet effet de trous alignés avec ceux à métalliser. Les feuilles 38 et 35 sont ensuite superposées de manière à faire coïncider les secteurs 39 et 36.

Le sandwich est complété par superposition d'une part d'une feuille supérieure comportant des secteurs carrés 49 pourvus chacun d'une ouverture centrale 51, plus large que l'ouverture 51', et présentant autour de celle-ci un cadre 61 sérigraphié permettant la brasure ultérieure d'un capot, et d'autre part d'une feuille inférieure portant des secteurs carrés 62. Chacun des secteurs carrés 62 comporte une série externe d'ouvertures 63, et une série interne d'ouvertures 65 s'inscrivant chacun sur le contour d'un carré de même côté que respectivement ceux définis par les perçages 37 et 57. Les ouvertures 63 et 65 sont également métallisées, de manière à former des métallisations respectivement 47' et 42', par de la pâte à sérigraphier, comme les ouvertures 37, 57 et 40. D'autre part, la partie inférieure de chaque secteur 62 comporte des métallisations sérigraphiées 48 et 43 formant des pattes de connexion en liaison électrique avec les métallisations des ouvertures 63 et 65 respectivement.

Après cuisson de la céramique et rupture des blocs ainsi obtenus le long des lignes de clivage constituées par les perçages superposés, on obtient des embases 50 tels que représentées aux figures 8a et 8b. On notera que sur ces figures, on a laissé subsister pour faciliter la compréhension des traits de séparation entre les secteurs 49, 39, 36 et 62. En réalité, étant donné que la céramique est cuite, l'ensemble forme un bloc homogène.

Selon les figures 8a et 8b, deux rangées de connexions 45 et 41 superposées sont raccordées à la face inférieure de l'embase par des métallisations décalées d'un demi-pas et disposées pour les unes sur les faces latérales de l'embase 50 et pour les autres dans des ouvertures internes. La première série de ces connexions 46, 47, 47' est disposée dans une rainure 37, 40 définie par les bords subsistants des perçages 37, 40 et 63 après clivage. La deuxième série de ces connexions 42, 42' est disposée dans des ouvertures internes à l'embase et venant de la superposition des ouvertures 57 et 65.

Chaque connexion de la rangée inférieure de connexions comporte une première section rectiligne 41 s'étendant entre les secteurs 39 et 36 depuis une première extrémité où elle est destinée à être connectée à un composant disposé au fond de la cuvette 51'', cette connexion étant facilitée par une zone 55 formant gradin, c'est-à-dire que les ouvertures 51'' sont légèrement plus grandes que les ouvertures 51'', jusqu'à un bord extérieur où elle est en contact électrique avec une deuxième section rectiligne 42 disposée dans une ouverture correspondante 57. Cette deuxième section rectiligne se prolonge par une troisième section 42' disposée dans une ouverture correspondante 65, puis par une patte 43 s'étendant sur une petite distance sous la face inférieure 44 de l'embase 50 en vue de sa soudure sur un substrat. La feuille portant les secteurs 62 a été, à cet effet, sérigraphiée sur sa face inférieure comme représenté à la figure 8c.

Chaque connexion de la rangée supérieure de connexions comporte une première section rectiligne 45 s'étendant entre le secteur 38 et le secteur 49 depuis une première extrémité où elle est destinée à être connectée à un composant disposé au fond de la cuvette 51', cette connexion étant facilitée par une zone 56 formant gradin, c'est-à-dire que l'ouverture 51 du secteur 49 est légèrement plus grande que l'ouverture 51' du secteur 39, jusqu'à un bord extérieur du boîtier où elle est en contact électrique avec une deuxième section rectiligne 46 disposée dans une des rainures 40 obtenues par la séparation des blocs réalisée après cuisson en brisant ceux-ci le long des lignes données par les ouvertures 40. Cette deuxième section rectiligne se prolonge avec continuité électrique par une troisième section rectiligne 47 disposée dans la rainure 37 située dans le prolongement de ladite rainure 40, puis par une quatrième section rectiligne 47' disposée dans la rainure 63 située dans le prolongement de ladite rainure 37, et se termine, bien entendu toujours avec continuité électrique, par une patte conductrice 48 et s'étendant sur une petite distance sous la face inférieure 44 de l'embase 50 en vue de sa soudure sur un substrat.

Sur les figures, on a représenté les pattes 43 dirigées vers l'intérieur du boîtier. La technique de sérigraphie a une finesse suffisante pour que ces pattes 43 soient dirigées vers l'extérieur du boîtier, de manière à être inter-digitées avec les pattes 48. Dans ce cas, elles s'étendent préférentiellement jusqu'au bord du boîtier de manière à permettre une inspection visuelle. D'autre part, on évitera en pratique de métalliser les perçages 63 situés dans les angles de l'embase.

La céramique peut être à base de 96% d'alumine à laquelle on ajoute un liant, un dispersant et un défloculant, ainsi qu'un minéralisateur ($MgO$ ou $Ca$) pour abaisser la température de frittage à 1500—1600°C. L'encre de sérigraphie peut comporter (en poids) 100 parties de tungstene, 2,5 parties de nitrocellulose (liant), 12,5 parties de lactate de butyle (dispersant) et 0,5 partie d'huile de mehnaden (dispersant et défloculant).

A titre d'exemple les métallisations ont des épaisseurs de 10 à 20 microns, la métallisation 70 est un carré de 7,62 mm de côté, de même que l'ouverture 51''. L'ouverture 51' est un carré de 10 mm de côté et l'ouverture 51, un carré de 12,40 mm de côté. Les dimensions extérieures du boîtier sont celles nécessitées par la mise en place des connexions au pas de 1,27 mm pour chaque rangée.

**Revendications**

1. Embase pour circuit intégré formée d'un boîtier (1) comportant n, avec $n \geqslant 2$, rangées de conducteurs de sortie (5, 9) disposés à intervalles réguliers sur le pourtour du boîtier selon un pas donné, ces conducteurs présentant des portions terminales dépassant du boîtier en vue de sa connexion électrique sur un circuit d'utilisation, ces rangées étant décalées les unes par rapport aux autres de $1/n^{ième}$ de pas, caractérisée en ce qu'au moins une rangée émerge d'au moins une face latérale du boîtier et au moins une autre rangée émerge de la face inférieure du boîtier au voisinage du bord qui jouxte ladite face latérale.

2. Embase selon la revendication 1, caractérisée en ce que les portions terminales des conducteurs de sortie d'une des rangées sont repliées vers le boîtier (1) et ceux de l'autre rangée vers l'extérieur du boîtier.

3. Embase selon la revendication 2, caractérisée en ce que les portions terminales des conducteurs de sortie (5) de la rangée qui émerge de la face latérale du boîtier (1) sont repliées vers le boîtier et celles des conducteurs de sortie (9) de la rangée qui émerge de la face inférieure du boîtier sont repliées vers l'extérieur du boîtier.

4. Embase selon l'une des revendications 2 ou 3, caractérisée en ce que ce repliement est réalisé autour d'un contour sensiblement parallélépipédique en matériau isolant (6).

5. Embase selon l'une des revendications 2 ou 3, caractérisée en ce que pour au moins une des rangées les conducteurs de sortie sont repliés autour d'un contour sensiblement parallélépipédique en matériau isolant et pour au moins une autre rangée après passage des conducteurs dans des ouvertures ménagées dans ledit contour.

6. Embase selon l'une des revendications 4 ou 5, caractérisée en ce que le contour (6) comporte des faces latérales dont une au moins porte des rainures (31) dans lesquelles les conducteurs sont guidés en amont de leurs extrémités repliées.

7. Embase selon l'une des revendications 4 à 6, caractérisée en ce que le contour est constitué par une pièce isolante maintenue en place uniquement par les connecteurs repliées autour d'elle.

8. Embase selon la revendication 7, caractérisée en ce que la pièce isolante est en matériau plastique.

9. Embase pour circuit intégré formée d'un boîtier comportant deux rangées de conducteurs de sortie disposés à intervalles réguliers sur le pourtour du boîtier selon un pas donnée, ces conducteurs présentant des portions terminales dépassant du boîtier en vue de sa connexion électrique sur un circuit d'utilisation, ces rangées étant décalées les unes par rapport aux autres d'un demi-pas et débouchant sur la face inférieure du boîtier, caractérisée en ce que le boîtier est en céramique et que les conducteurs sont du type sérigraphiés et comportent deux séries de conducteurs (45, 41) superposées pour la connexion électrique depuis l'intérieur du boîtier jusqu'aux parois latérales de celui-ci, la série supérieure étant raccordée électriquement à la partie inférieure de l'embase par des premières portions conductrices (46, 47, 47') situées sur le bord du boîtier, disposées chacune dans une rainure, et se prolongeant par une patte (48) située sous l'embase en vue de la connexion électrique de celles-ci, et la série inférieure étant raccordée électriquement à la partie inférieure de l'embase par des secondes portions conductrices (42, 42') disposées dans des trous débouchant sur la face inférieure de l'embase, les secondes portions conductrices se prolongeant par une patte (43) située sous l'embase en vue de la connexion électrique de celles-ci, les trous et les rainures étant décalés l'un par rapport à l'autre latéralement d'un demi-pas.

10. Embase selon l'une des revendications précédentes, caractérisée en ce que le boîtier est en matériau conducteur, en ce qu'il comporte une plaquette intermédiaire disposée à l'intérieur du boîtier et destinée à recevoir au moins un circuit intégré, et au moins deux rangées de passages isolants décalées l'une par rapport à l'autre et à travers lesquelles passent lesdites conducteurs de sortie.

**Patentansprüche**

1. Basis für integrierte Schaltung, gebildet durch ein Gehäuse (1), umfassend n, mit n ≥ 2, Reihen von Ausgangsleitern (5, 9) die in regelmäßigen Abständen auf dem Umfang des Gehäuses gemäß einem gegebenen Schritt angeordnet sind, wobei diese Leiter Anschlußteile aufweisen, die vom Gehäuse hinsichtlich dessen elektrischer Verbindung mit einem Verbraucherkreis vorstehen, wobei diese Reihen mit 1/ntel Schritt in bezug aufeinander versetzt sind, dadurch gekennzeichnet, daß wenigstens eine Reihe aus einer Seitenwand des Gehäuses austritt und wenigstens eine weitere Reihe aus der Unterseite des Gehäuses benachbart dem Rand austritt, der nahebei der Seitenwand ist.

2. Basis nach Anspruch 1, dadurch gekennzeichnet, daß die Anschlußteile der Ausgangsleiter einer der Reihen zum Gehäuse (1) und diejenigen der anderen Reihe zur Außenseite des Gehäuses hin umgebogen sind.

3. Basis nach Anspruch 2, dadurch gekennzeichnet, daß die Anschlußteile der Ausgangsleiter (5) der Reihe, die aus der Seitenwand des Gehäuses (1) austreten, zum Gehäuse hin umgebogen sind, und diejenigen der Ausgangsleiter (9) der Reihe, die von der Unterseite des Gehäuses austreten, zur Außenseite des Gehäuses umgebogen sind.

4. Basis nach einem der Ansprüche 2 oder 3, dadurch gekennzeichnet, daß dieses Umbiegen um eine im wesentlichen parallelepipedförmige Kontur aus Isoliermaterial (6) ausgeführt ist.

5. Basis nach einem der Ansprüche 2 oder 3, dadurch gekennzeichnet, daß wenigstens eine der Reihen der Ausgangsleiter um eine im wesentlichen parallelepipedförmige Kontur aus Isoliermaterial umgebogen ist und für wenigstens eine weitere Reihe nach Durchführung der Leiter in in der Kontur ausgesparten Öffnungen.

6. Basis nach einem der Ansprüche 4 oder 5, dadurch gekennzeichnet, daß die Kontur (6) Seitenwände umfaßt, von denen wenigstens eine Nuten (31) trägt, in denen die Leiter stromaufwärts ihrer umgebogenen Enden geführt sind.

7. Basis nach einem der Ansprüche 4 bis 6, dadurch gekennzeichnet, daß die Kontur durch ein lediglich durch die um sie umgebogenen Leiter am Platz gehaltenes Isolierteil gebildet ist.

8. Basis nach Anspruch 7, dadurch gekennzeichnet, daß das Isolierteil aus Kunststoffmaterial ist.

9. Basis für integrierte Schaltung, gebildet durch ein Gehäuse, umfassend zwei Reihen von in regelmäßigen Abständen auf dem Umfang des Gehäuses gemäß einem gegebenen Schritt angeordneten Ausgangsleitern, wobei diese Leiter Anschlußteile aufweisen, die vom Gehäuse hinsichtlich dessen elektrischer Verbindung mit einem Verbraucherkreis vorstehen, wobei diese Reihen bezüglich einander um einen halben Schritt versetzt sind und auf der Unterseite des Gehäuses münden, dadurch gekennzeichnet, daß das Gehäuse aus Keramik ist und daß die Leiter vom Serigraphietyp sind und zwei Serien von für die elektrische Verbindung vom Inneren des Gehäuses bis zu dessen Seitenwänden übereinanderliegenden Leitern (45, 41) umfassen, wobei die obere Serie elektrisch mit dem unteren Teil der Basis durch erste Leiterteile (46, 47, 47') verbunden ist, die auf dem Rand des Gehäuses liegen, jeweils in einer Nut angeordnet sind und sich durch einen unter der Basis liegenden Lappen (48) hinsichtlich deren elektrischen Anschlusses verlängern, und wobei die untere Serie elektrisch mit dem unteren Teil der Basis durch zweite Leiterteile (42, 42') verbunden ist, die in auf der Innenseite der Basis mündenden Löchern angeordnet sind, wobei die zweiten Leiterteile sich durch einen unter der Basis liegenden Lappen (43) hinsichtlich deren elektrischen Anschlusses verlängern, wobei die Löcher und die Nuten bezüglich einander seitlich um einen halben Schritt versetzt sind.

10. Basis nach einem der vorhergehenden Ansprüche, dadurch gekennzeichnet, daß das Gehäuse aus Leitermaterial ist, daß es eine im Inneren des Gehäuses angeordnete und zur Aufnahme wenigstens einer integrierten Schaltung bestimmte Zwischenplatte und mindestens zwei Reihen von isolierenden Durchführungen umfaßt, die bezüglich einander versetzt sind und durch die die Ausgangsleiter verlaufen.

**Claims**

1. Base for an integrated circuit, formed of a case (1) comprising n, with n ≥ 2, rows of outlet conductors (5, 9) disposed at regular intervals over the periphery of the case according to a given pitch, these conductors having terminal portions extending beyond the case with a view to its electrical connection on a utilisation circuit, these rows being staggered in relation to one another by 1nth of pitch, characterized in that at least one row emerges from at least one lateral face of the case and at least one other row emerges from the lower face of the case in the vicinity of the edge which is situated next to the said lateral face.

2. Base according to claim 1, characterized in that the terminal portions of the outlet conductors of one of the rows are turned in towards the case (1), and those of the other row towards the exterior of the case.

3. Base according to claim 2, characterized in that the terminal portions of the outlet conductors (5 of the row which emerges from the lateral face of the case (1) are turned in towards the case and those of the outlet conductors (9) of the row which emerges from the lower face of the case are turned in towards the exterior of the case.

4. Base according to one of claims 2 or 3, characterized in that this turning in is realised around a substantially parallepipedic outline of insulating material (6).

5. Base according to one of claims 2 or 3, characterized in that for at least one of the rows the outlet conductors are turned in around a substantially parallepipedic outline of insulating material and for at least one other row after passing of the conductors in openings arranged in the said contour.

6. Base according to one of claims 4 or 5, characterized in that the outline (6) comprises lateral faces, one of which at least has grooves (31) in which the conductors are guided above their turned in ends.

7. Base according to one of claims 4 to 6, characterized in that the outline is constituted by an insulating piece held in place solely by the conductors which are turned in around it.

8. Base according to claim 7, characterized in that the insulating piece is of plastic material.

9. Base for an integrated circuit formed of a case comprising two rows of outlet conductors disposed at regular intervals over the periphery of the case according to a given pitch, these conductors having terminal portions extending beyond the case with a view to its electrical connection on a utilisation circuit, these rows being staggered in relation to one another by a half pitch and opening out on the lower face of the case, characterized in that the case is of ceramic material and that the conductors are of the screenprinted type and comprise two superposed series of conductors (45, 41) for the electrical connection from the interior of the case up to the lateral walls thereof, the upper series being connected electrically to the lower part of the base by first conductive portions (46, 47, 47') situated on the edge of the case, each disposed in a groove, and extending by a tab (48) situated beneath the base with a view to the electrical connection thereof, and the lower series being connected electrically to the lower part of the base by second conductive portions (42, 42') disposed in holes opening out on the lower face of the base, the second conductive portions extending by a tab (43) situated beneath the base with a view to the electrical connection thereof, the holes and the grooves being staggered in relation to one another laterally by a half pitch.

10. Base according to one of the preceding claims, characterized in that the case is of conductive material, in that it comprises a small intermediate plate disposed in the interior of the case and intended to receive at least one integrated circuit, and at least two rows of insulating passages staggered one in relation to the other and through which the said outlet conductors pass.

0 113 292

FIG_1

FIG_2

FIG_3-a

FIG_3-b

FIG_4

FIG_5

FIG_6

1

FIG_7-a

2/2  40  51'  39

45

38

FIG_7-b

37  57  36

41

51'

35

FIG_7-c

36

37

51"  57

FIG_8-a

41  61  56  55  51  51'  50  49

42

39

42'  62  44  51"  70  36

43

FIG_8-b

61  45  56  51  51'  50  49

46

55

39

47

47'

48  62  44  51"  70  36

FIG_8-c

63  62

44

65  43

48

FIG_8-d

49

51

61